Europäisches Patentamt

European Patent Office

Office européen des brevets

(11) Veröffentlichungsnummer: **0 299 110**
**A1**

## EUROPÄISCHE PATENTANMELDUNG

(21) Anmeldenummer: 87111436.9

(22) Anmeldetag: 07.08.87

(51) Int. Cl.⁴ **E06B 5/18 , H05K 9/00 , B32B 17/10 , C03C 27/12**

(30) Priorität: 14.07.87 DE 3723219

(43) Veröffentlichungstag der Anmeldung:
18.01.89 Patentblatt 89/03

(84) Benannte Vertragsstaaten:
AT BE CH DE ES FR GB GR IT LI LU NL SE

(71) Anmelder: Ge Elektronische Schutzsysteme GmbH
Further Strasse 33
D-8490 Cham(DE)

(72) Erfinder: Gruber, Max
Further Strasse 33
D-8490 Cham(DE)

(74) Vertreter: Czowalla, Ernst
Patentanwälte E. Czowalla P. Matschkur
Dr.-Kurt-Schumacher-Strasse 23 Postfach 9109
D-8500 Nürnberg 11(DE)

(54) **Fensterverglasung für abgeschirmte Räume.**

(57) Fensterverglasung, insbesondere für Hf-abgeschirmte Räume unter Verwendung aufgedampfter Edelmetallschichten (4) mit wenigstens zwei Scheiben (1, 2) aus Glas oder Kunststoff, wobeidie Verglasung eine die aufgedampfte Edelmetallschicht (4) tragende Kunststoff-Folie (3) aufweist, die beidseitig je einer verschweißfähigen Kunststoff-Folie (5, 6) und diese nach außen je einer Glas- oder Kunststoffscheibe (1, 2) anliegt und daß alle diese zu einer durchsichtigen Einheit verschweißt sind.

FIG. 1

## Fensterverglasung für abgeschirmte Räume

Die Erfindung richtet sich auf eine Fensterverglasung, insbesondere für Hf-abgeschirmte Räume mit wenigstens zwei Scheiben aus Glas oder Kunststoff unter Verwendung aufgedampfter Edelmetallschichten.

Die Abschirmung von Räumen soll diese und die dar.n enthaltenen Geräte und/oder Personen gegen Störstrahlungen von außen nach innen ebenso wie gegen Abstrahlung von innen nach außen schützen. Bestimmte empfindliche Geräte, wie Datenverarbeitungsgeräte, vor allem aber Datenspeicher, elektronische Steuergeräte und viele andere entsprechende Einrichtungen mit hoch sensiblen Sensoren, erfordern eine Sicherung zunächst gegen von außen auf sie einwirkende Störungen, die ihre Funktion beeinträchtigen könnten oder gar möglich machen oder Fehlfunktionen auszulösen in der Lage sind. Diese Vorrichtungen verlangen aber andererseits auch eine Sicherung dagegen, daß aus Ihnen unkontrolliert Signale nach außen abgegeben werden, die dort von Unbefugten aufgenommen und gegebenenfalls verwertet werden könnten. Eine solche elektromagnetische Abschirmung ist unabhängig von einer aktustischen Abschirmung und bedarf anderer Maßnahmen zu ihrer Realisierung. Gleichwohl können beide miteinander kombiniert werden, ohne daß dies im Rahmen dieser Betrachtung Berücksichtigung findet.

Ein durch Metallbleche, Metallfolien oder Metallgewebe umkleideter Raum arbeitet nach dem Prinzip des Faraday'schen Käfigs und gehört zum bekannten Stand der Technik. Die Arbeit in solchen Räumen stellt jedoch für das Personal eine hohe Belastung dar, weil die Abschirmung im allgemeinen eine Fensterlosigkeit voraussetzt. Es sind jedoch auch schon Räume mit Fenstern versehen worden, die einen mehrschichtigen Aufbau tragen und sich zur HF-sicheren Abschirmung einer Edelmetallbedampfung einer Glas-oder Kunststoffscheibe bedienen. Zusätzlich verwenden solche Fenster in Abstand von der Metallbedampfung angeordnete Metalldrahtgewebe, die beispielsweise zwischen zwei Glasscheiben eingebettet sein können. Eine andere Alternative sieht vor, das Metalldrahtgewebe in eine Kunststoffolie einzuschließen oder einzuschmelzen. Hierunter leidet allerdings die Durchsichtigkeit solcher Fenster. Vielfach sind sie nur noch begrenzt durchscheinend. Gerade die optische Durchsicht, zumindest von innen nach außen, ist aber eine wesentliche Forderung, um den Aufenthalt in derart abgeschirmten Räumen für das Personal erträglich zu gestalten.

Die Erfindung nimmt sich dieser Problematik an und schafft ein gegenüber den bisher bekannten Gestaltungen wesentlich verbessertes Fenster für Hf-abgeschirmte Räume, dessen Durchsicht weitgehend erhalten bleibt, so daß der abgeschirmte Raum eine Tageslichtausleuchtung aufweist und die Durchsicht zumindest nach außen erlaubt. Dieser Forderung trägt die Erfindung bei einer Fensterverglasung der eingangs bezeichneten Art in der Weise Rechnung, daß die Verglasung eine die aufgedampfte Edelmetallschicht tragende Kunstoff-Folie aufweist, die beidseitig je einer schweißfähigen Kunstoff-Folie und diese nach außen je einer Glas- oder Kunststoffscheibe anliegt, wobei alle diese Scheiben und Folien zu einer durchsichtigen Einheit miteinander verschweißt sind. Die erfindungsgemäße Ausbildung führt zu einer äußerst kompakten Gestaltung einer speziellen Fensterverglasung, die die Fensterkonstruktion wesentlich vereinfacht und infolge ihrer kompakten Bauform die Konstruktion solcher Räume außerordentlich verbilligt. Der Wirkungsgrad einer derartigen Abschirmung ist unerwartet hoch, und es liegt andererseits auf der Hand, daß die Durchsicht eines solchen Fensters gegenüber denjenigen Konstruktionen wesentlich verbessert ist, die zur Abschirmung mehrere hintereinander liegende Metallgewebe-Ein lagen erfordern. Die Verglasung ist zu einer Einheit zusammengefügt, kann als solche auf Lager gehalten und in der gewünschten Größe hergestellt oder auf diese zugeschnitten werden. Die bei einer Vielscheiben-Anordnung unvermeidliche Montage auf der Baustelle entfällt völlig.

Besonders vorteilhaft ist es, wenn die Edelmetallschicht auf eine Polyesterfolie aufgedampft ist. In weiterer Ausgestaltung sieht die Erfindung vor, die bedampfte Folie zwischen zwei Folien auf Polyvinylbutyral anzuordnen. Ein solcher Kunststoff ist das Butyraldehydacetal des Polyvinylalkohols. Sein Vorzug liegt in der Vulkanisierbarkeit und der Licht- und Wärmebeständigkeit auch bei höheren Temperaturen. Die Schichtdicke ist vergleichsweise gering und infolge der ihr innewohnenden Eigenschaften vollauf geeignet, die bedampfte Kunstoff-Folie mit den außen liegenden Glas- und oder Kunststoffscheiben zuverlässig zu einer Einheit zu verbinden. In verschweißtem Zustand ist eine solche komplexe Fensterverglasung noch voll durchsichtig, womit sie sich vor allem den mit ein oder mehreren Metallgewebeeinlagen versehenen Verglasungen wesentlich überlegen erweist.

Die Edelmetallschicht ist nach einem weiteren Merkmal der Erfindung durch eine aufgeklebte oder aufgeschweißte leitende Metall-folie mit einer Raumabschirmung kontaktiert und unmittelbar oder über diese an Masse oder Erde angelegt, so daß der erforderliche Abschirmzweck zuverlässig erreicht wird. Eine andere Alternative sieht dagegen vor, die Edelmetallschicht durch anliegende Kontaktfedern mit einer Raumabschirmung zu kontaktieren. Welcher Ausführungsform der Vorzug gegeben wird, richtet sich nach den Umständen des Einzelfalls. In aller Regel übernimmt die Kontaktierung zugleich die mechanische Halterung der Verglasung in einem Rahmen. Eine besonders vorteilhafte Ausführungsform zeichnet sich dadurch aus, daß eine der beiden äußren Scheiben aus Glas oder Kunststoff mit der ihr anliegenden schweißfähigen Kunststoff-Folie gegenüber der anderer äußeren Scheibe verkürzt ist und daß auf der freiliegenden Edelmetallschicht die Kontaktelemente aufliegen.

Um die Abschirmung auch unter erschwerten Gebrauchsbedingungen und längerer Lebensdauer wirksam zu erhalten, kann der Außenrand der verschweißten Einheit feuchtigkeitsgeschützt sein. Um einen besonders wirksamen Abschirmeffekt zu erhalten und/oder auch dem Gesichtspunkt verstärkter akkustischer Abschirmung genügen zu können, können mehrere miteinander verschweißte Einheiten der erfindungsgemäßen Verglasung in Abstand hintereinander angeordnet sein. Die Abstandhalter sind von konventionellen Fensterverglasungen her bekannt.

Ein spezielles Anwendungsgebiet der erfindungsgemäßen Verglasungen neben der Abschirmung von Räumen ist die Anwendung als Sichtschirm für Datenverarbeitungsanlagen. Hierfür haben sich diese Art Verglasungen als besonders attraktiv erwiesen. Insbesondere kann auf diese Weise das vielfach störende Flimmern oder ähnliche Erscheinungen verhindert werden.

Weitere Merkmale, Einzelheiten und Vorteile der Erfindung ergeben sich aus der folgenden Beschreibung einiger bevorzugter Ausführungsformen der Erfindung, sowie anhand der Zeichnung. Hierbei zeigen:

Fig. 1 eine auseinandergezogene abgebrochene Darstellung der Verglasung,

Fig. 2 die Kontaktierung der verschweißten Einheit gegenüber dem Rahmen;

Fig. 3 eine abgewandelte Ausführungsform;

Fig. 4 eine Verdoppelung der Verglasung, unter Einspannung in einen Rahmen und

Fig. 5 eine andere Ausbildung der Kontaktierung.

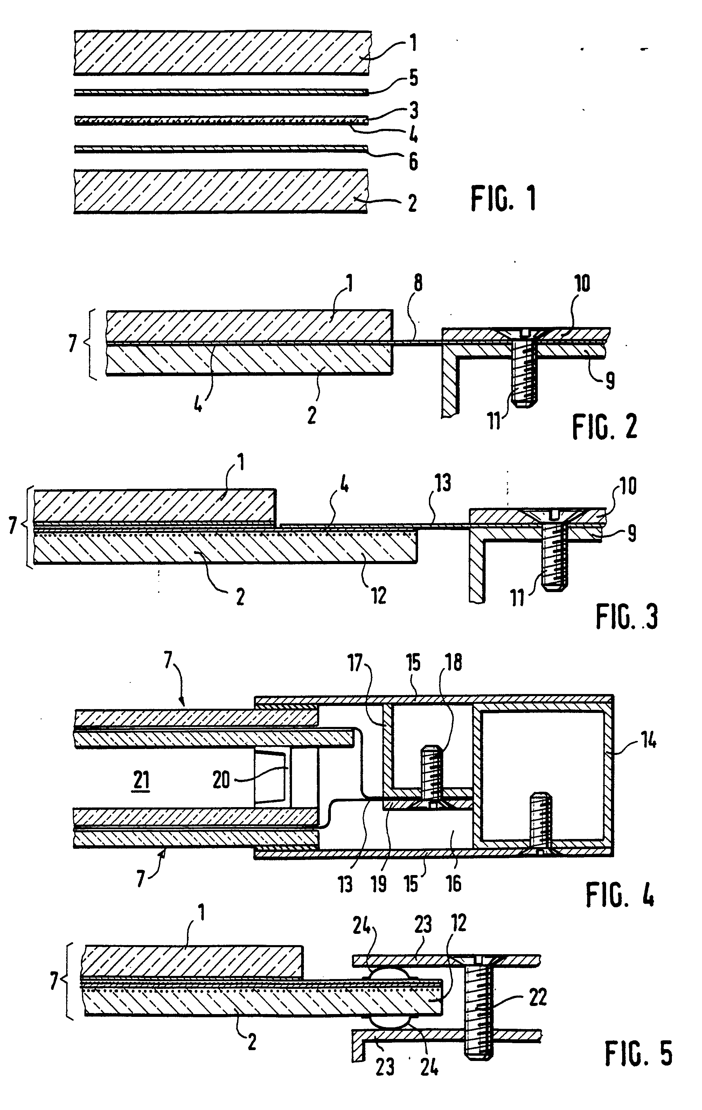

Der Aufbau der Verglasung ist in Fig. 1 dargestellt. An beiden Außenseiten, d. h. innen und außen ist je eine Scheibe Floatglas oder Kunststoffglas 1 bzw. 2 angeordnet. Zwischen beiden Glasscheiben 1 und 2 ist eine Kunststoff-Folie 3, im allgemeinen eine Polyesterfolie angeordnet, die, in Fig. 1 unten, eine aufgedampfte Edelmetallschicht 4 trägt. Zwischen dieser Folie 3 und jeder der beiden Scheiben 1 und 2 ist eine schweißfähige Kunststoff-Folie 5, 6 vorzugsweise aus Polyvinylbutyral angeordnet. Diese Einheit aus - ohne die aufgedampfte Schicht - fünf Einzelschichten 1, 2, 3, 5 und 6, wird durch flächigen Druck und gegebenenfalls Wärme zu einer Einheit verschweißt, die nur durch Zerstörung wieder aufgehoben werden kann. In den weiteren Figuren ist die im Einbauzustand dargestellte Einheit mit 7 bezeichnet. Bei der Ausführungsform nach Fig. 2 ist die zwischen die beiden Außenschichten 1 und 2 eingeschlossene Edelmetallschicht 4 an ein nach außen führendes Metallgewebe 8 angeschlossen, und dieses ist zwischen zwei leitende Rahmenelemente, nämlich ein Winkelprofil 9 und eine Leiste 10 durch Schrauben 11 eingespannt.

Eine andere Alternative läßt die Fig. 3 erkennen. Dort ist die Scheibe 1 gegenüber der Scheibe 2 verkürzt. Auf dem überstehenden Ende 12 der Scheibe 2 liegt die aufgedampfte Schicht 4 frei. Sie ist mit einem Metallgewebe 13, einer Metallfolie od.dgl. verbunden. Die Verbindung wird zweckmäßig durch einen leitenden Kleber hergestellt. Dieses Kontaktierungselement ist wiederum zwischen die Rahmenteile 9 und 10 eingespannt.

Die Fig. 4 läßt einen grob vereinfacht wiedergegebenen Fensterrahmen 14 erkennen, der zwei parallel nach innen auskragende Platten 15 aufweist, in deren Zwischenraum 16 ein Profilstück 17 liegt, auf dem mittels einer Verschraubung 18 eine Leiste 19 zum elektromagnetischen Einspannen der Metallgewebe oder Folien 13 befestigt ist. Zwischen den auskragenden Platten 15 sind bei der wiedergegebenen Ausführungsform nach Fig. 4 zwei Einheiten 7 eingespannt, zwischen denen ein Abstandhalter 20 angeordnet ist. Der Zwischenraum 21 kann gegebenenfalls luftleer gemacht werden.

Eine weitere Form der Kontaktierung zeigt die Ausführungsform nach Fig. 5, bei welcher weiderum die Scheibe 2 gegenüber der Scheibe 1 vorsteht. Zwischen den beiden durch eine Verschraubung 22 gegeneinander verspannten Platten 23 und dem vorstehen dem Rahmen, zum anderen aber auch der elastischen Einspannung der Eiheit 7 in den Rahmen dienen.

## Ansprüche

1. Fensterverglasung, insbesondere für Hf-abgeschirmte Räume unter Verwendung aufgedampfter Edelmetallschichten mit wenigstens zwei Scheiben aus Glas oder Kunststoff, dadurch gekennzeichnet, daß die Verglasung eine die aufgedampfte Edelmetallschicht (4) tragende Kunststoff-Folie (3) aufweist, die beidseitig je einer verschweißfähigen Kunststoff-Folie (5, 6) und diese nach außen je einer Glas- oder Kunststoffscheibe (1, 2) anliegt und daß alle diese zu einer durchsichtigen Einheit (7) verschweißt sind.

2. Fensterverglasung nach Anspruch 1, dadurch gekennzeichnet, daß die Edelmetallschicht (4) auf eine Polyesterfolie (3) aufgedampft ist.

3. Fensterverglasung nach Anspruch 1 oder 2, dadurch gekennzeichnet, daß die bedampfte Folie (3) zwischen zwei Folien (5, 6) aus Polyvinylbutyral angeordnet ist.

4. Fensterverglasung nach einem der Ansprüche 1 bis 3, dadurch gekennzeichnet, daß die Edelmetallschicht (4) durch eine aufgeklebte oder aufgeschweißte leitende Metallfolie (13) mit einer Raumabschirmung kontaktiert ist.

5. Fensterverglasung nach einem der Ansprüche 1 bis 3, dadurch gekennzeichnet, daß die Edelmetallschicht (4) durch anliegende Kontaktfedern (24) mit einer Raumabschirmung kontaktiert ist.

6. Fensterverglasung nach Anspruch 5, dadurch gekennzeichnet, daß eine der beiden äußeren Scheiben (1, 2) mit der ihr anliegenden schweißfähigen Kunststoff-Folie (6) gegenüber der anderen äußeren Scheibe verkürzt ist und auf der freiliegenden Edelmetallschicht (4) die Kontaktelemente aufliegen.

7. Fensterverglasung nach einem der Ansprüche 1 bis 6, dadurch gekennzeichnet, daß der Außenrand der verschweißten Einheit (7) feuchtigkeitsgeschützt ist.

8. Fensterverglasung nach einem der Ansprüche 1 bis 7, dadurch gekennzeichnet, daß mehrere miteinander verschweißte Einheiten (7) in Abstand hintereinander angeordnet sind.

9. Verwendung der Verglasungseinheit (7) als Sichtschirm für Datenverarbeitungsgeräte.

EP 0 299 110 A1

FIG. 1

FIG. 2

FIG. 3

FIG. 4

FIG. 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | FR-A-2 495 130 (SOLAR CONTROL FRANCE) * Seite 1, Zeile 35 - Seite 2, Zeile 15; Figuren 1,2 * | 1,2,3 | E 06 B 5/18 H 05 K 9/00 B 32 B 17/10 C 03 C 27/12 |
| Y | --- | 4,5,8,9 | |
| X | FR-A-1 564 493 (ENGLISH ELECTRIC CO.) * Seite 1, Spalte 1, Zeile 1 - Seite 3, Spalte 2, Zeile 34; Figuren 1-4 * --- | 1,2,3 | |
| X | DD-C- 86 689 (SCHILLER) * Spalte 3, Zeilen 54-62; Spalte 4, Zeile 54 - Spalte 5, Zeile 31; Spalte 5, Zeile 42 - Spalte 6, Zeile 64; Figuren 1-4 * --- | 1,2,3 | |
| Y | DE-U-7 932 609 (WIRTZ) * Seite 2, Zeile 12 - Seite 5, Zeile 33; Figuren 1,2 * --- | 4,8 | |
| Y | US-A-4 514 585 (PAYNTON) * Spalte 3, Zeilen 6-47; Figuren 1,2 * --- | 5,9 | |
| A | US-A-2 401 552 (COX) * Spalte 1, Zeile 30 - Spalte 4, Zeile 6; Figuren 1-4 * --- | 1,8 | |
| A | US-A-4 247 737 (JOHNSON) * Spalte 2, Zeile 45 - Spalte 3, Zeile 17; Figuren 1-3 * ----- | 6 | |

**RECHERCHIERTE SACHGEBIETE (Int. Cl.4)**

E 06 B
H 05 K
B 32 B

Der vorliegende Recherchenbericht wurde für alle Patentansprüche erstellt

| Recherchenort | Abschlußdatum der Recherche | Prüfer |
|---|---|---|
| DEN HAAG | 20-10-1988 | DEPOORTER F. |